# EUROPEAN PATENT APPLICATION

(11) **EP 3 196 772 A2**
(43) Date of publication of application: **26.07.2017**
(21) Application number: 16195442.5
(22) Date of filing: 25.10.2016
(51) Int. Cl.: G06F 15/78

(54) **HYBRID SYSTEM INTEGRATING PACKAGE-ON-PACKAGE SOC AND EMBEDDED MULTI-CHIP PACKAGE ON ONE MAIN CIRCUIT BOARD**

(30) Priority: 19.01.2016 US 201662280158 P; 19.10.2016 US 201615297170
(71) Applicant: MediaTek Inc., Hsin-Chu 300 (TW)
(72) Inventor: Chang, Sheng-Ming, 241 New Taipei City (TW); Chang, Chun-Wei, 104 Taipei City (TW)
(74) Representative: Hoefer & Partner Patentanwälte mbB

(57) **Abstract**

A hybrid system includes a printed circuit board (PCB) having a main surface, a package-on-package (PoP) having a bottom package mounted on the main surface of the PCB and a top package stacked on the bottom package, and a multi-chip package (MCP) on the main surface of the PCB. The bottom package includes a system-on-chip (SoC) and the top package includes at least one on-package dynamic random access memory (DRAM) die accessible to the SoC. The MCP includes at least one on-board DRAM die accessible to the SoC via a PCB trace.

## Description

### Background

The present disclosure relates to a hybrid platform or a hybrid system that integrates package-on-package SoC (System-on-Chip) and embedded multi-chip package (eMCP) onto one main circuit board or printed circuit board for mobile applications.

Recently, electrical products tend to have higher efficiencies and be smaller. Therefore, sizes of the semiconductor chips mounted on the printed circuit boards (PCBs) are continuing to be miniaturized, while frequencies of electronic signals transmitted on the PCBs are being increased.

Modem personal electronic devices such as mobile phones have highly integrated, low-power electronics. These devices use System-on-Chip (SoC), Package-on-Package (PoP), and non-volatile NAND flash memories. A SoC integrates multiple functions onto one chip such as general purpose processing, accelerated processing, storage control, and communications links. In order to meet the stringent power and space constraints common to mobile devices, these chips combine a central processing unit (CPU) with other components into a single compact physical package.

Some computing systems use dynamic random access memory (DRAM) integrated circuits (ICs) in their main memory. As known in the art, DRAM retains information by storing a certain amount of charge on a capacitor in each memory cell to store a logical one or alternatively, a logical zero.

Recently, high-density LPDDR4 (also known as "Low Power DDR4") DRAM has been introduced on mobile platform. In order to guarantee the system performance, IP (Intellectual Property) providers of the memory controller often define the package and PCB design constraints to reduce product risks. These design constraints may increase the package size and LPDDR4 PCB area to cost up the whole system cost.

To get higher density memory, the total height of the PoP SoC inevitably increases because more DRAM chips are stacked in the PoP SoC. In the near future, the PoP SoC may not conform to the stringent space constraints to high-end products because these high-end products are getting thinner and thinner. For MCP products, current main-stream products are two-channel/32bit MCP. Using byte-mode/ smaller-die may be a possible solution to get higher density. However, byte-mode operation will also limit the operation speed of DRAM from heavier loading for CA (Command/Address) signals.

### Summary

It is one object of the invention to provide a hybrid system having both an on-package DRAM memory die and an on-board DRAM memory die installed on the same printed circuit board or main circuit board.

According to one embodiment of the invention, a hybrid system includes a printed circuit board having a main surface, a package-on-package (PoP) having a bottom package mounted on the main surface of the PCB and a top package stacked on the bottom package, and a multi-chip package (MCP) on the main surface of the PCB. The bottom package includes a system-on-chip (SoC) and the top package includes at least one on-package dynamic random access memory (DRAM) die accessible to the SoC. The MCP includes at least one on-board DRAM die accessible to the SoC via a PCB trace.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention, and are incorporated in and constitute a part of this specification. The drawings illustrate embodiments of the invention and, together with the description, serve to explain the principles of the invention. In the drawings:
FIG. 1 is a schematic, cross-sectional diagram showing an exemplary hybrid system according to one embodiment of the invention; and
FIG. 2 is a schematic layout diagram showing an exemplary hybrid system according to one embodiment of the invention.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made without departing from the spirit and scope of the present disclosure. The following detailed description is, therefore, not to be taken in a limiting sense, and the scope of embodiments of the present invention is defined only by the appended claims.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "lateral" or "vertical" may be used herein to describe a relationship of one element, layer or region to another element, layer or region as illustrated in the figures. It will be understood that these terms are intended to encompass different orientations of the device in addition to the orientation depicted in the figures.

This invention pertains to a hybrid system having both an on-package DRAM memory die and an on-board DRAM memory die installed on the same printed circuit board or main circuit board. The on-board DRAM memory die may be accessed by the memory controller or processor in the SoC through a PCB trace or a high-frequency memory bus on the printed circuit board.

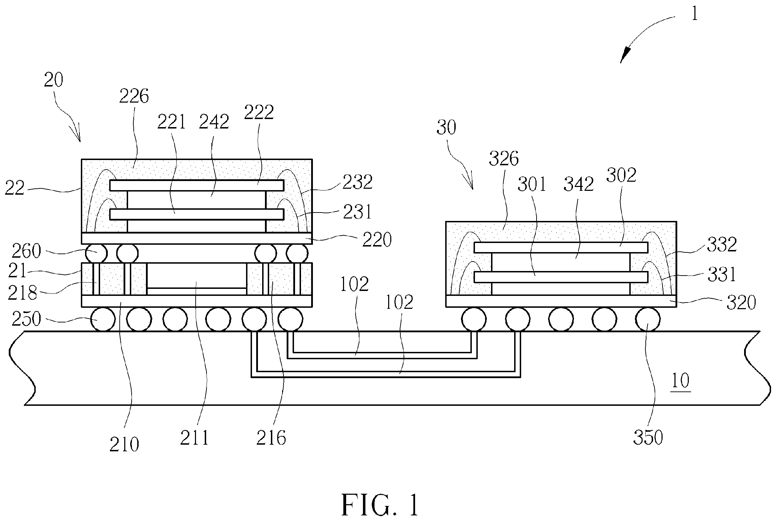

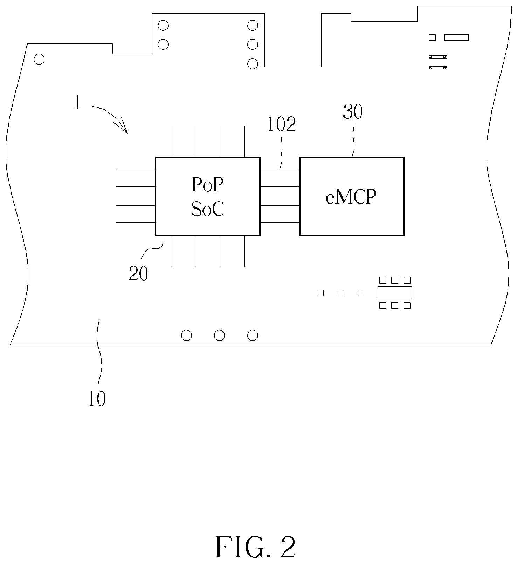

FIG. 1 is a schematic sectional diagram showing an exemplary hybrid system according to one embodiment of the invention. FIG. 2 is a schematic layout diagram of the exemplary hybrid system. As shown in FIG. 1 and FIG. 2, the hybrid system 1 comprises a printed circuit board (PCB) or main circuit board 10. The PCB 10 mechanically supports and electrically connects electronic components using conductive tracks, traces, pads and other features etched from copper sheets laminated onto a non-conductive substrate. Depending upon the design requirements, the PCB 10 may be single sided (one copper layer), double sided (two copper layers) or multi-layer (outer and inner layers). Multi-layer PCBs allow for much higher component density. Conductors on different layers are connected with plated-through holes or vias.

According to the embodiment, the PCB 10 may contain components such as capacitors, resistors or active devices embedded in the substrate. The circuit board substrate is usually composed of dielectric composite materials. The composites contain a matrix (usually an epoxy resin), a reinforcement (usually a woven, sometimes nonwoven, glass fibers), and in some cases a filler, e.g. ceramics, is added to the resin. It is understood that the detailed structure of the PCB 10 is not shown for the sake of simplicity.

According to the embodiment, a Package-on-Package (PoP) 20 is mounted directly on a main surface of the PCB 10. According to the embodiment, the PoP 20 combines vertically discrete System-on-Chip (SoC) and memory packages. According to the embodiment, the PoP 20 stacks chips in a 3D structure that allows for denser packing and it is used for memories on top of processors to form a PoP SoC configuration. Two or more packages are installed atop each other, i.e. vertically stacked, with a standard interface to route signals between them.

According to the embodiment, the PoP 20 comprises a bottom package 21 comprising a SoC 211 that may integrate one or more processing cores (CPU), a graphics processing unit (GPU), cache memory, and/or other electronics necessary to provide mobile computing functions within a single physical package. According to the embodiment, the SoC 211 may further include memory controllers configured to read and write data to memory. According to the embodiment, the SoC 211 may be packaged in a form of wafer level package (WLP) or fan-out WLP, but is not limited thereto.

According to the embodiment, the SoC 211 may be encapsulated by a molding compound 216. The bottom package 21 may be attached directly onto the main surface of the PCB 10 through connection elements 250 of the PoP 20. The connection elements 250 may comprise solder bumps, solder balls or copper pillar bumps. According to the embodiment, an interposer 210 such as a redistribution layer (RDL) interposer, a silicon interposer or a through-substrate-via (TSV) interposer may be disposed between the conductive structure 250 and the SoC 211 so as to fan out input/output (I/O) pads on the active surface of the SoC 211.

According to the embodiment, a top package 22 is mounted directly on top of the bottom package 21. The top package 22 has at least one DRAM die (on-package DRAM memory die). For example, two DRAM dies 221 and 222 are shown in this embodiment. According to the embodiment, the DRAM dies 221 and 222 are DDR (Double Data Rate) DRAM dies, for example, 64-bit Single-channel 1600 MHz LPDDR4-3200 DRAM dies, but not limited thereto. It is understood that other types of DDR DRAM may be used, for example, dual channel DDR DRAM or quad channel DDR DRAM, but is not limited thereto. The DRAM dies 221 and 222 serve as a main memory for processing the data of the processor(s) in the SoC 211.

According to the embodiment, the DRAM dies 221 and 222 are vertically stacked on a packaging substrate 220 with a spacer 242 interposed therebetween. According to the embodiment, the DRAM dies 221 and 222 may be electrically connected to the packaging substrate 220 through the bond wires 231 and 232, respectively. It is understood that the electrical connection between the DRAM dies 221 and 222 and the packaging substrate 220 is for illustration purposes only. Other suitable electrical connection approaches such as TSV may be employed in other embodiments. According to the embodiment, the DRAM dies 221 and 222, the bond wires 231 and 232, and the top surface of the packaging substrate 220 are encapsulated and covered by a molding compound 226.

According to the embodiment, the top package 22 is attached to the top of the bottom package 21 through a plurality of connection elements 260 such as bumps or pillars. These connection elements 260 may be electrically coupled to the interposer 210 through respective through mold vias (TMVs) 218. The SoC 211 can access the DRAM dies 211 and 222 through the path composed of interposer 210, the TMVs 218, the connection elements 260, the packaging substrate 220, and the bond wires 231 and 232.

According to the embodiment, a multi-chip package (MCP) 30 such as an embedded MCP (eMCP) is mounted on the main surface of the PCB 10 in proximity to the PoP 20. The MCP 30 comprises at least one DRAM die (on-board DRAM memory die). For example, two DRAM dies 301 and 302 are shown in this embodiment. According to the embodiment, the DRAM dies 301 and 302 are DDR (Double Data Rate) DRAM dies, for example, 64-bit Single-channel 1600 MHz LPDDR4-3200 DRAM dies, but not limited thereto. It is understood that other types of DDR DRAM may be used, for example, dual channel DDR DRAM or quad channel DDR DRAM, but is not limited thereto. Like the DRAM dies 221 and 222, the DRAM dies 301 and 302 also serve as a main memory for processing the data of the processor(s) in the SoC 211. High-frequency memory buses (PCB traces) 102 are provided in the PCB 10 such that data or signals may communicate between the PoP 20 and the MCP 30.

According to the embodiment, the DRAM dies 301 and 302 are vertically stacked on a packaging substrate 320 with a spacer 342 interposed therebetween. According to the embodiment, the DRAM dies 301 and 302 may be electrically connected to the packaging substrate 320 through the bond wires 331 and 332, respectively. It is understood that the electrical connection between the DRAM dies 301 and 302 and the packaging substrate 320 is for illustration purposes only. Other suitable electrical connection approaches such as TSV may be employed in other embodiments. According to the embodiment, the DRAM dies 301 and 302, the bond wires 331 and 332, and the top surface of the packaging substrate 320 are encapsulated by a molding compound 326.

According to another embodiment, the MCP 30 may be an eMCP (embedded MCP) of package type for mobile memory, which integrates a mobile DRAM and a flash memory into one chip package. For example, the MCP may comprise a mobile DDR and an embedded MultiMediaCard (eMMC). In this case, one the two DRAM dies 301 and 302 in FIG. 1 may be replaced with a flash memory. The flash memory may be a NOR flash memory in which a cell array has a NOR structure or a NAND flash memory in which a cell array has a NAND structure. The NOR flash memory or the NAND flash memory is provided in order to store data that should not be removed even though power is turned off, such as boot codes of a mobile device, programs, communication data, or storage data. Flash memories are used in a variety of devices including cell phones, digital cameras, and portable computers. The SoC 211 may include memory controllers configured to read and write data to the flash memory.

By providing such configuration as depicted in FIG. 1 and FIG. 2, the SoC 211 can access the DRAM chips or dies 221, 222, 301, 302 through different access paths (a path inside the PoP 20 and a path outside the PoP 20). The SoC 211 can access the DRAM chips or dies 221, 222 through the path composed of interposer 210, the connection elements 260, the packaging substrate 220, and the bond wires 231 and 232. The SoC 211 can access the DRAM chips or dies 301, 302 through the high-frequency memory buses 102 in the PCB 10. The processor(s) in the SoC 211 may be coupled to the DRAM chips or dies 301, 302 in one or more memory channels via PCB traces 102.

The hybrid platform 1 composed of PoP 20 and MCP 30 ensures larger density when compared to either conventional PoP-only platform or conventional MCP-only platform. For example, the 8GB DRAM of the conventional PoP-only platform can now be separated into 4GB-PoP and 4GB-MCP as the hybrid system 1 described above with state-of-art technology without suffering PoP height limitation or MCP byte-mode speed degradation.

In some embodiments, the differences between the DRAM in the top package 22 and the DRAM in the MCP 30 may include, but are not limited to: access latency, whether the memory device includes a delay-locked loop (DLL) in DRAM, the number of command and address pins, data size per package, topology, maximum frequency, burst length, Reliability- Availability-Serviceability (RAS), VDDQ (i.e., supply voltage to input and output).

For example, in an embodiment where the DRAM in the top package 22 is an LPDDR4 (the 4^{th} generation of LPDDR) memory and the DRAM in the MCP 30 is a DDR4 memory, the differences may include but are not limited to the following: LPDDR4 does not have a DLL in DRAM but DDR4 has at least a DLL; LPDDR4 has 6 signaling pins for command and address but DDR4 has 22 such pins; LPDDR4 data size per package is x16/x32/x64 (where "x" means "times" or "a multiple of" and "/" means "or") but DDR4 data size per package is x4/x8, LPDDR4 topology is point-to-point but DDR4 is a dual-inline memory module (DIMM); the maximum frequency of LPDDR4 is 4266 MT/s but DDR4 is 3200 MT/s (where MT/s means mega-transfers per second); the burst length of LPDDR4 is 16 or 32 but DDR4 is 8; LPDDR4 has no RAS support but DDR4 has data cyclic redundancy check (CRC) and command/address parity; LPDDR4 operates VDDQ at 1.1 v but DDR4 operates VDDQ at 1.2 v. Moreover, with respect to the access latency, LPDDR4 outperforms DDR4 for large data transfers; e.g., when the data transfer size is greater than a threshold, e.g., approximately 570 bytes. Thus, LPDDR4 is more suited for I/O intensive workload data and DDR4 is more suited for computation-intensive workload data.

In some embodiments, the DRAM in the top package 22 and the DRAM in the MCP 30 may have a number of similarities despite the aforementioned differences. The similarities may include but are not limited to: byte-addressability, volatile memory, command and address protocols for accessing memory, double data rate architecture (i.e., two data transfers per clock), differential clock inputs and data strobes. An example of such DRAM in the top package 22 and the DRAM in the MCP 30 is LPDDR4 and DDR4, respectively. Although LPDDR4 and DDR4 are used as an example, it should be understood that that the DRAM in the top package 22 and the DRAM in the MCP 30 may be any memory devices that has one or more of the aforementioned differences and one or more of the aforementioned similarities.

In one embodiment, the DRAM in the top package 22 may be an LPDDR memory device, such as an LPDDR4 or another generation of an LPDDR memory device. In one embodiment, the DRAM in the MCP 30 may be a DDR memory device, such as a DDR4 or another generation of a DDR memory device.

LPDDR is a class of SDRAM that operates at a low supply voltage to reduce power consumption. LPDDR has been widely adopted by mobile devices where power consumption is a major concern. As mentioned above, both LPDDR and DDR are byte-addressable, and both are volatile memory devices that require refresh once every few micro-seconds to retain the contents. One advantage of LPDDR is that it consumes less power than the corresponding generation of DDR. For example, the latest generation LPDDR4 may operate at 1.1V, which is lower than DDR4 with a standard voltage at 1.2V. LPDDR4 also supports an improved power saving low frequency mode, which can bring the clock speed down for further battery savings when performing simple background tasks. Experimental results show that LPDDR4 may save 33%-87% power compared to DDR4 in various usage modes such as active pre-charge, active standby, burst read, burst write, etc. Additional similarities and differences between LPDDR4 and DDR4 have been described above.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A hybrid system, comprising:
a printed circuit board (PCB, 10) having a main surface;
a package-on-package (PoP, 20) comprising a bottom package (21) mounted on the main surface of the PCB and a top package (22) stacked on the bottom package, wherein the bottom package comprises a system-on-chip (SoC, 211) and the top package comprises at least one on-package dynamic random access memory (DRAM) die (221, 222) accessible to the SoC; and
a multi-chip package (MCP, 30) directly mounted on the main surface of the PCB, wherein the MCP comprises at least one on-board DRAM die (221, 222) accessible to the SoC via a PCB trace (102).

2. The hybrid system according to claim 1, wherein the SoC integrates at least one processing core (CPU) and a graphics processing unit (GPU) in the bottom package.

3. The hybrid system according to claim 2, wherein the SoC further comprises a memory controller configured to read and write data to the on-package DRAM die and the on-board DRAM die.

4. The hybrid system according to claim 1, wherein the PCB trace is a high-frequency memory bus.

5. The hybrid system according to claim 1, wherein the MCP is an embedded MCP (eMCP) of package type for mobile memory, wherein the eMCP integrates the on-board DRAM die and a flash memory.

6. The hybrid system according to claim 5, wherein the flash memory comprises an embedded MultiMediaCard (eMMC).

7. The hybrid system according to claim 1, wherein the on-package DRAM die and the on-board DRAM die are both volatile memory dies and have double data rate architectures.

8. The hybrid system according to claim 1, the on-package DRAM die is a LPDDR4 memory die and the on-board DRAM die is a DDR4 memory die.

9. The hybrid system according to claim 1, wherein the on-package DRAM die has no delay-locked loop (DLL) and the on-board DRAM die has at least a DLL.

10. The hybrid system according to claim 1, wherein numbers of signaling pins for command and address which the on-package DRAM die and the on-board DRAM die are electrically connected to respectively are different.

11. The hybrid system according to claim 1, wherein the on-package DRAM die and the on-board DRAM die have different supply voltages for input and output.

12. The hybrid system according to claim 1, wherein the on-package DRAM die is used for I/O intensive workload data and the on-board DRAM die is used for computation-intensive workload data.

13. The hybrid system according to claim 1, wherein the on-package DRAM die has an access latency higher than the on-board DRAM.
